# EUROPEAN PATENT APPLICATION

(11) **EP 2 012 356 A2**
(43) Date of publication of application: **07.01.2009**
(21) Application number: 08159602.5
(22) Date of filing: 03.07.2008
(51) Int. Cl.: H01L 23/467

(54) **Heatsink and cooling apparatus**

(30) Priority: 06.07.2007 JP 2007178776
(71) Applicant: Tyco Electronics AMP K.K., Kawasaki, Kanagawa 213-8535 (JP)
(72) Inventor: Suzuki, Mitsuru, Kawasaki Kanagawa 213-8535 (JP)
(74) Representative: Johnstone, Douglas Ian

(57) **Abstract**

A natural convection-type heatsink (30) for a cooling apparatus for cooling a heating element is suitable for an LED lighting device and has increased cooling capacity. The heatsink (30) comprises a metal plate (31) in the form of a band rolled around a central axis (CL) to have the shape of a scroll and having a base edge, wherein the height of the scroll from the base edge gradually increases towards the central axis (CL). A plurality of air intake openings (32) pass through the metal plate (31) and are in a lower portion of the metal plate (31) in the vicinity of the base edge. The cooling apparatus comprises the heatsink (30), a heating element and a printed circuit board. The heatsink (30) is mounted on an upper surface of the printed circuit board and the heating element is mounted on an undersurface thereof, wherein the heating element is located in a central position with reference to the central axis (CL) and opposite the heatsink (30).

## Description

The present invention relates to a natural convection-type heatsink and cooling apparatus for cooling a heating element, and particularly to a natural convection-type heatsink and cooling apparatus which are suitable for cooling an LED that is used as an illumination light source.

Forced convection-type cooling apparatuses having a relatively large cooling capacity have been widely used in the past as cooling apparatuses for cooling the heating elements. The term "forced convection-type cooling apparatus" refers to a cooling apparatus having a construction in which a fan is added to a heatsink. The cooling apparatus shown in FIG. 10 (see JP 2004-063563A) is a known example of a convection-type cooling apparatus. FIG. 10 is a schematic perspective view showing a state in which a fan is removed from a conventional cooling apparatus.

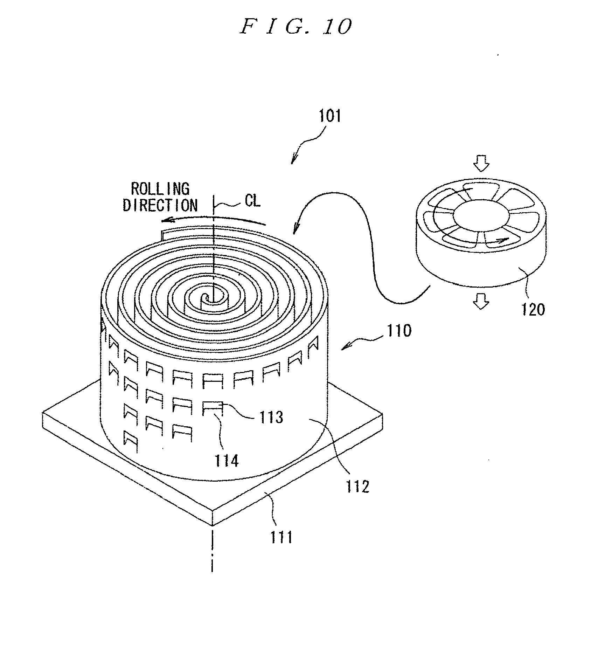

The cooling apparatus 101 shown in FIG. 10 is constructed from a heatsink 110 and a fan 120.

Here, the heatsink 110 is constructed from a radiating fin 112 that is obtained by rolling a band-form metal plate in a spiral shape, and a radiating plate 111 that is provided on one end (toward the bottom in FIG. 10) in the direction of the central axis CL of the rolled radiating fin 112. A heating element (not shown in the figure) is designed to be attached to the surface of the radiating plate 111 on the side opposite from the radiating fin 112. Furthermore, a plurality of substantially rectangular holes 113 that pass through in the direction of thickness of the radiating fin 112 are formed in the radiating fin 112. Each hole 113 is formed by cutting a portion of the radiating fin 112 and raising this portion inwardly (towards the rolled central axis CL). Tongue parts 114 that are created when the portions of the radiating fin 112 are cut and raised to form the respective holes 113 are inclined toward the rolled central axis CL so as to conform to the flow of air passing through the holes 113 from the inside toward the outside.

Moreover, the fan 120 is an axial flow fan that is mounted in a detachable manner on the other end (toward the above in FIG. 10) of the radiating fin 112 in the direction of the rolled central axis CL. The direction of rotation of the fan 120 is the same as the direction of rolling of the radiating fin 112. Thus, cool air from the fan 120 is blown into the radiating fin 112.

In the cooling apparatus 101 constructed in this manner, the radiating fin 112 has a shape that is obtained by rolling a band-form material in a scroll-like manner, so that it is possible to easily change the pitch dimension between plates in the radial direction, and to increase the heat dissipation area without increasing the overall size of the heating element cooling apparatus 101.

Furthermore, because the direction of rolling of the radiating fin 112 and the direction of rotation of the fan 120 coincide, the direction of swirling of cool air that is blown into the fan 120 and the direction of rolling of the radiating fin 112 can be caused to coincide, so that the cool air can be caused to flow smoothly into the radiating fin 112.

Moreover, because the plurality of holes 113 that pass through in the direction of thickness of the radiating fin 112 are formed in the radiating fin 112, it is possible to expect the effect of increasing the heat transfer coefficient at the corner portions (edges) of the tongue parts 114 and the effect of suppressing the growth of a thermal boundary layer by disturbing the flow of the cool air passing through the respective holes 113.

In addition, the tongue parts 114 are inclined toward the rolled central axis CL along the flow of the air passing through the holes 113. Therefore, the air passing through the holes 113 from the inside toward the outside can be flown smoothly into the radiating fin 112.

Incidentally, LED lighting devices have recently appeared in the technical field that requires cooling apparatuses for cooling heating elements. In these LED lighting devices, there is demand for higher-power LEDs to obtain high brightness (e.g., demand to allow an increase in the power consumption from a conventional value of approximately 4 W to approximately 8 W to 15 W).

However, natural convection-type cooling apparatuses (cooling apparatuses based solely on heat dissipation by means of a heatsink without providing a fan) which tend to have insufficient cooling capacity have been used in the past in the cooling in LED lighting devices, so that the production of higher-power LEDs finds itself in a difficult situation.

In the cooling of LED lighting devices, furthermore, it is also conceivable to use forced convection-type cooling apparatuses such as the cooling apparatus 101 shown in FIG. 10.

However, because a fan is used in forced convection-type cooling apparatuses such as the cooling apparatus 101 shown in FIG. 10, noise or the like becomes an issue, so that it is unrealistic to use such a forced convection-type cooling apparatus in the cooling of LED lighting devices.

Accordingly, it is an object of the present invention to provide a natural convection-type heatsink and cooling apparatus for cooling a heating element which are suitable for LED lighting devices or the like and which have increased cooling capacity.

In order to achieve the object described above, the heatsink of claim 1 is a heatsink for cooling a heating element, wherein this heatsink is formed by rolling a band-form metal plate in the shape of a scroll with the rolled central axis as the center, and is constructed such that the height on one side in the direction of the central axis is gradually increased from the outside in the radial direction towards the central portion in the radial direction, and a plurality of air intake openings that pass through in the direction of thickness of the metal plate are formed towards the other end in the direction of the central axis.

Furthermore, the heatsink of claim 2 is the heatsink according to claim 1, wherein a plurality of circular arc-shaped fins that are cut and raised inwardly in the radial direction are formed in the metal plate, and each of the plurality of fins is cut and raised from the metal plate such that the line connecting both cut-and-raised end parts extends parallel to the direction of the central axis, such that the plane of each fin extends parallel to the direction of the central axis, and such that the angle formed by the plane of each fin and the tangential line of the scroll-form metal plate is an acute angle.

Moreover, the cooling apparatus of claim 3 is a cooling apparatus comprising the heatsink according to claim 1 or 2 and a printed wiring board on the undersurface of which a heating element is mounted, wherein the heatsink is mounted, with the side of the other end in the direction of the central axis being at the bottom, on the upper surface of the printed wiring board in a vertical direction in relation to the heating element in a position in which the heating location is located in the center in the radial direction.

The heatsink of claim 1 is formed by rolling a band-form metal plate in the shape of a scroll with the rolled central axis as the center, and is constructed such that the height on one side in the direction of the central axis is gradually increased from the outside in the radial direction toward the central portion in the radial direction. Therefore, a temperature difference in the direction of the central axis can be created easily at the central portion of the heatsink in the radial direction. Moreover, in cases where the heatsink is mounted, with the side of the other end in the direction of the central axis being at the bottom, on the upper side of the heating element in the vertical direction and in a position in which the heating element is located in the center in the radial direction, the temperatures of the heatsink and the air inside the heatsink are such that the temperatures in the center of the heatsink in the radial direction are higher than those toward the outside in the radial direction, so that the temperature difference in the direction of the central axis can be made to be greater in the center in the radial direction. Accordingly, the chimney effect at the center of the heatsink in the radial direction can be made to be greater than the chimney effect toward the outside in the radial direction, so that the flow velocity of the updraft can be increased at the center of the heatsink, thus making it possible to create a pressure gradient in which the pressure is gradually lowered from the outside toward the center in the radial direction. Furthermore, a plurality of air intake openings that pass through in the direction of thickness of the metal plate are formed toward the other end in the direction of the central axis, so that air can be taken in from the outside of the heatsink via the air intake openings. Moreover, air flow from the outside of the heatsink toward the center in the radial direction is generated due to the pressure difference described above (which is such that the pressure is gradually lowered from the outside toward the center in the radial direction), so that spiral-form air flow is generated in the heatsink as a whole. Consequently, the air taken in from the outside of the heatsink via the air intake openings undergoes convection toward the center in the radial direction. This air convection causes the air that is warmed up inside the heatsink to be expelled by air that is not warmed up much, so that it is possible to produce a natural convection-type heatsink for cooling a heating element with increased cooling capacity.

In addition, in the heatsink of claim 2, a plurality of circular arc-shaped fins that are cut and raised inwardly in the radial direction are formed in the metal plate in the heatsink according to claim 1. Therefore, the heat radiating from the fins are directed inwardly in the radial direction, so that the temperatures of the heatsink and the air inside the heatsink become gradually higher from the outside in the radial direction toward the inside in the radial direction, and become highest at the center in the radial direction. Consequently, the fins can cause the air to act in a direction that maintains the condition of making the temperatures the highest at the center in the radial direction. Furthermore, each of the plurality of fins is cut and raised from the heatsink such that the line connecting both cut-and-raised end parts extends parallel to the direction of the central axis of the heatsink, and such that the angle formed by the plane of each fin and the tangential line of the scroll-form metal plate is an acute angle. Because of this, the planes of the respective fins guide the air undergoing convection inside the heatsink towards the center of the heatsink in the radial direction, and therefore can cause the air to act in a direction that minimizes the reduction in the flow velocity of the air.

Moreover, the cooling apparatus of claim 3 comprises the heatsink according to claim 1 or 2 and a printed wiring board on the undersurface of which a heating element is mounted, and the heatsink is mounted, with the side of the other end in the direction of the central axis being at the bottom, on the upper surface of the printed wiring board in the vertical direction in relation to the heating element in a position in which the heating element is located in the center in the radial direction. Therefore, the temperatures of the heatsink and the air inside the heatsink are such that the temperatures in the center in the radial direction of the heatsink are higher than towards the outside in the radial direction, and the temperature difference in the direction of the central axis can be made to be greater in the center in the radial direction. Accordingly, the chimney effect at the center of the heatsink in the radial direction can be made to be greater than the chimney effect towards the outside in the radial direction, so that the flow velocity of the updraft can be increased at the center of the heatsink, thus making it possible to create a pressure gradient in which the pressure is gradually lowered from the outside toward the center in the radial direction.

Embodiments of the present invention will be described below with reference to the figures, in which:
FIG. 1 is a schematic sectional view showing a state in which the heatsink according to a first embodiment of the present invention is mounted in a lighting device;
FIGS. 2A, 2B and 2C show the heatsink of FIG. 1, with FIG. 2A being a plan view,
FIG. 2B being a front view in a state in which a portion of this heatsink is cut, and FIG. 2C being an enlarged view of the portion indicated by arrow 2C in FIG. 2A;
FIG. 3 is a plan view in a state in which a metal plate constituting the heatsink of FIGS. 2A, 2B and 2C is unrolled;
FIG. 4 is a sectional view along line 4-4 in FIG. 3;
FIGS. 5A, 5B and 5C show a modified example of the heatsink of FIG. 1, with FIG. 5A being a plan view, FIG. 5B being a front view in a state in which a portion of this heatsink is cut, and FIG. 5C being an enlarged view of the portion indicated by arrow 5C in FIG. 5A;
FIG. 6 is a plan view in a state in which a metal plate constituting the heatsink of FIG. 5 is unrolled;
FIG. 7 is a sectional view along line 7-7 in FIG. 6;
FIGS. 8A, 8B and 8C show the heatsink according to a second embodiment of the present invention, with FIG. 8A being a plan view, FIG. 8B being a front view in a state in which a portion of this heatsink is cut, and FIG. 8C being an enlarged view of the portion indicated by arrow 8C in FIG. 8A;
FIG. 9 is a plan view in a state in which a metal plate constituting the heatsink of FIG. 8 is unrolled; and
FIG. 10 is a schematic perspective view showing a state in which the fan is removed from a conventional cooling apparatus.

A key or explanation of many of the reference numerals and symbols shown in the figures is given below:
- 3:: LED (heating element)
- 10:: Cooling apparatus
- 30, 30', 50:: Heatsink
- 31, 51:: Metal plate
- 32:: Air intake opening
- 33, 53:: Fin
- 33a, 53a:: Line connecting both cut-and-raised end parts
- 33b, 53b:: Plane of fin
- t:: Tangential line of heatsink
- θ:: Angle formed by plane of fin and tangential line of heatsink
- CL:: Rolled central axis

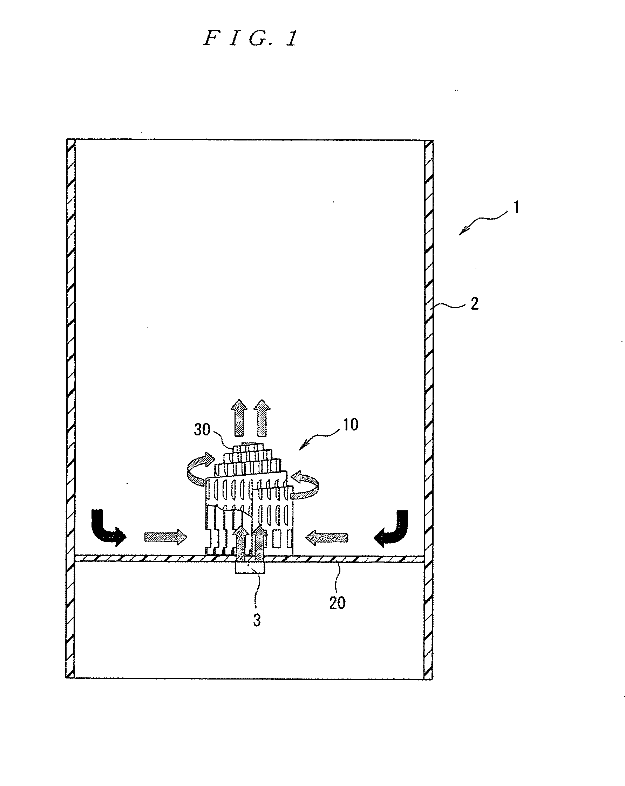

In FIG. 1, a printed wiring or printed circuit board 20, on the undersurface of which an LED (heating element) 3 is mounted, is installed inside the housing 2 of a lighting device 1. Furthermore, a heatsink 30 for cooling the LED 3 that generates heat is mounted on the upper surface or one side of the printed wiring board 20. A double-sided board having Cu layers respectively formed on the upper surface and undersurface thereof is used for the printed wiring board 20; the LED 3 is mounted on the undersurface (opposite side), and the heatsink 30 is brazed (soldered) by reflow to the Cu layer on the upper surface. The heatsink 30 is designed to be mounted on the upper surface of the printed wiring board 20 in the vertical direction in relation to the LED 3 in a position in which the LED 3 is located in the central portion in the radial direction. The heatsink 30 and printed wiring board 20 constitute a cooling apparatus 10. The housing 2 is formed in a cylindrical shape, but may be formed in another shape. Furthermore, the housing 2 is made of resin. The reason that the housing 2 is made of resin is that, compared to the case of using a metal (aluminum material), a material made of resin affords a higher degree of freedom in design and a lower cost. Note that the housing 2 made of resin has a disadvantage compared to the housing 2 made of metal from the standpoint of dissipating heat generated by the LED 3. For this reason, there is demand to further increase the heat dissipation effect by means of the heatsink 30 and cooling apparatus 10.

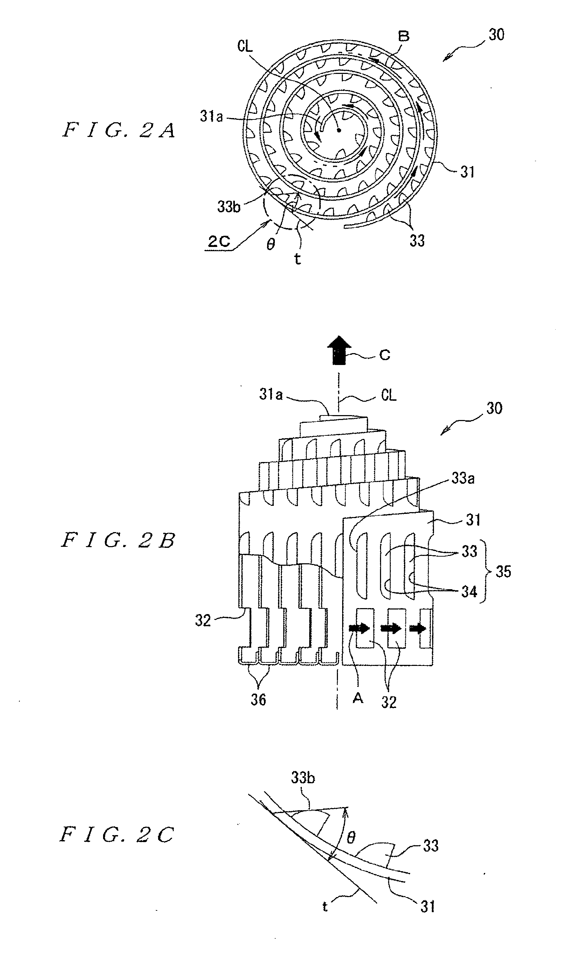

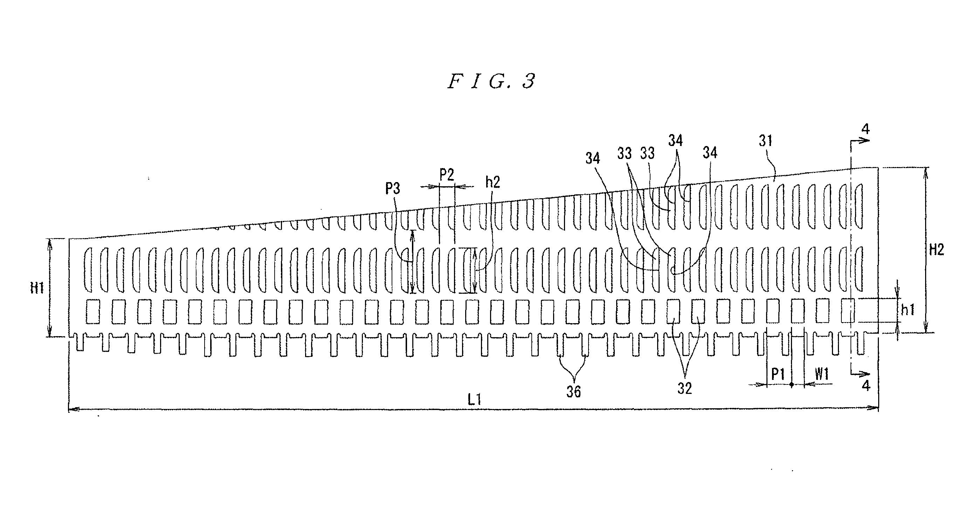

Here, as is shown in FIGS. 2A and 2B, the heatsink 30 is formed by rolling a band-form metal plate 31 in the shape of a scroll with the rolled central axis CL as the center. The heatsink 30 can be mass-produced by successively working a single long band-form metal plate 31. The rolled central axis CL is a virtual axis. The direction of rolling of the metal plate 31 is clockwise as seen in plan view in FIG. 2A, but may also be reversed, i.e., counterclockwise. For example, an aluminum material can be used for the metal plate 31. As is shown in FIG. 3, the metal plate 31 that is in the unrolled state has a trapezoidal shape in which the height is gradually increased from one end edge toward the other end edge in the direction of length (left-right direction in FIG. 3), with the height at the first end edge in the direction of length being designated as H1, and the height at the second end edge in the direction of length being designated as H2, which is higher than H1. The lower end or base edge (lower end edge in FIG. 3) of the metal plate 31 extends so as to be orthogonal to both the first end edge and second end edge in the direction of length, while the upper end edge of the metal plate 31 extends at an inclination from the first end edge to the second end edge in the direction of length. Therefore, when the metal plate 31 is rolled (like a scroll) such that the second end edge having the height H2 is on the inside, the height on one side (upper side) in the direction of the central axis is gradually increased from the outside in the radial direction toward the central portion 31 a in the radial direction as shown in FIGS. 2A and 2B.

Moreover, a plurality of air intake openings 32 that pass through in the direction of thickness of the metal plate 31 are formed toward the lower end in the direction of central axis of the heatsink 30 or in a lower portion of the metal plate 31 in the vicinity of the base edge as shown in FIG. 2B. As is shown in FIG. 3, each of the air intake openings 32 is formed to have a rectangular shape with a width of wl and a height (length in the vertical direction) of h1, and a plurality of these air intake openings 32 are arranged at a pitch of P1 along the direction of length of the metal plate 31. By forming the plurality of air intake openings 32, the surface area of the heatsink 30 is increased, so that the heat dissipation effect is increased. Furthermore, the air intake openings 32 have the function of taking in air from the outside of the heatsink 30 to the inside, but in addition to that, these air intake openings 32 also function as pilot holes when the metal plate 31 is rolled and when louver-form opening parts 35 (described later) are stamped and formed. If these air intake openings 32 are not formed, it is necessary to provide a portion for forming pilot holes on the outside of the metal plate 31 and to cut off the portion in which these pilot holes are formed after the completion of the heatsink 30. However, as a result of the air intake openings 32 functioning as such pilot holes, there is no need to form separate pilot holes on the outside of the metal plate 31 in that manner, so that material can be saved.

In addition, a plurality of louver-form opening parts 35 are formed in the heatsink 30 as shown in FIG. 2B. Each of the louver-form opening parts 35 comprises a circular or concave arc-shaped fin 33 formed by stamping and being inwardly formed in the radial direction and a slit-form opening (hereafter simply referred to as slit) 34 being produced as a result of forming the fin 33. Each of the plurality of fins 33 is cut and raised from the heatsink 30 (metal plate 31) about a fin axis parallel to the central axis such that the line 33a connecting both cut-and-raised end parts extends parallel to the direction of the central axis of the heatsink 30, i.e., in the direction of extension of the louver, as shown in FIG. 2B. Each fin 33 defines a fin plane between its fin axis and a distal end of the fin. Furthermore, each of the plurality of fins 33 is cut and raised from the heatsink 30 such that the plane 33b of each fin 33 extends parallel to the direction of the central axis, i.e., in the vertical direction, and also such that the angle θ formed by the plane 33b of each fin 33 and the tangential line t of the scroll-form heatsink 30 (metal plate 31) is an acute angle as shown in FIG. 2C. Moreover, the slits 34 are positioned above the air intake openings 32 and arranged in two rows, i.e., the upper and lower rows, as shown in FIG. 3. Each slit 34 is formed with a height (length in the vertical direction) of h2. The slits 34 in each row are arranged at a pitch of P2 along the direction of length of the metal plate 31. The upper-row slits 34 and lower-row slits 34 are arranged at a pitch of P3. Thus, by forming the plurality of louver-form opening parts 35 in the heatsink 30, the surface area of the heatsink 30 is increased, so that the heat dissipation effect is increased.

Furthermore, a plurality of leg parts 36 are provided on the lower end edge of the heatsink 30 (metal plate 31) at a specified pitch along the direction of length. These leg parts 36 are bent after the metal plate 31 is rolled into the shape of a scroll with the rolled central axis CL as the center such that the leg parts 36 on the outside in the radial direction respectively touch the metal plate 31 on the inside in the radial direction as shown in FIG. 2B. Moreover, the undersurfaces of the bent leg parts 36 are brazed (soldered) by reflow to the Cu layer formed on the upper surface of the printed wiring board 20, thus mounting the heatsink 30 on the printed wiring board 20. In this case, the heatsink 30 is mounted on upper surface of the printed wiring board 20 in the vertical direction in relation to the LED 3 in a position in which the LED 3 is located in the center in the radial direction.

In the lighting device 1 constructed in this manner, when the LED 3 generates heat, this heat is transferred to the heatsink 30 and the air inside the heatsink 30 via the printed wiring board 20. As a result, the temperatures of the heatsink 30 and the air inside the heatsink 30 rise. The temperatures of the heatsink 30 and the air inside the heatsink 30 are the highest at the center in the radial direction where the LED 3 is located, and become gradually lower towards the outside in the radial direction. Furthermore, the temperatures are higher in the lower portion of the heatsink 30, and lower in the upper portion of the heatsink 30. When the heatsink 30 is viewed as a whole, because there is a temperature difference between the lower portion and upper portion of the heatsink 30, an updraft is generated by the chimney effect.

Here, the heatsink 30 is formed by rolling the band-form metal plate 31 in the shape of a scroll with the rolled central axis CL as the center, and is constructed such that the height on one side (upper side) in the direction of the central axis is gradually increased from the outside in the radial direction toward the central portion 31a in the radial direction, so that a temperature difference in the direction of the central axis can be created easily at the central portion 31a of the heatsink 30 in the radial direction. Moreover, the heatsink 30 is mounted, with the side of the other end (side of the lower end) in the direction of the central axis being at the bottom, on the upper side of the LED 3 in the vertical direction and in a position in which the LED 3 is located in the center in the radial direction. Therefore, with regard to the temperatures of the heatsink 30 and the air inside the heatsink 30, the temperatures in the center in the radial direction of the heatsink 30 can be made to be higher than toward the outside in the radial direction, and the temperature difference in the direction of the central axis can be made to be greater in the center in the radial direction. Accordingly, the chimney effect at the center of the heatsink 30 in the radial direction is made to be greater than the chimney effect toward the outside in the radial direction, so that the flow velocity of the updraft in the direction of arrow C shown in FIG. 2B can be increased at the center of the heatsink 30, thus making it possible to create a pressure gradient in which the pressure is gradually lowered from the outside toward the center in the radial direction. Furthermore, the plurality of air intake openings 32 that pass through in the direction of thickness of the metal plate 31 are formed on the side of the second end (on the side of the lower end) in the direction of the central axis, so that air can be taken in from the outside of the heatsink 30 in the direction of arrow A shown in FIG. 2B via the air intake openings 32. Then, air flow from the outside of the heatsink 30 toward the center in the radial direction in the direction of arrow B shown in FIG. 2A is generated due to the pressure difference described above (which is such that the pressure is gradually lowered from the outside toward the center in the radial direction), so that spiral-form air flow is generated in the heatsink 30 as a whole. As a result, the air taken in from the outside of the heatsink 30 via the air intake openings 32 undergoes convection toward the center in the radial direction. This air convection causes the air that is warmed up inside the heatsink 30 to be expelled by air that is not warmed up much, so that it is possible to produce a natural convection-type heatsink 30 for cooling a heating element with increased cooling capacity.

Furthermore, a plurality of circular arc-shaped fins 33 that are cut and raised inward in the radial direction are formed in the heatsink 30. Consequently, the heat radiated from the fin parts 33 is directed inward in the radial direction, so that the temperatures of the heatsink 30 and the air inside the heatsink 30 become gradually higher from the outside in the radial direction toward the inside in the radial direction, and become highest at the center in the radial direction. Therefore, the fins 33 can cause the air to act in a direction that maintains the condition of making the temperatures the highest at the center in the radial direction.

Moreover, each of the plurality of fins 33 is cut and raised from the heatsink 30 such that the line 33a connecting both cut-and-raised end parts extends parallel to the direction of the central axis of the heatsink 30, and such that the angle θ formed by the plane 33b of each fin 33 and the tangential line t of the scroll-form metal plate 31 is an acute angle. Therefore, the planes 33b of the respective fins 33 guide the air undergoing convection inside the heatsink 30 towards the center of the heatsink 30 in the radial direction, thus making it possible to cause the air to act in a direction which is such that a reduction in the flow velocity of the air is as little as possible.

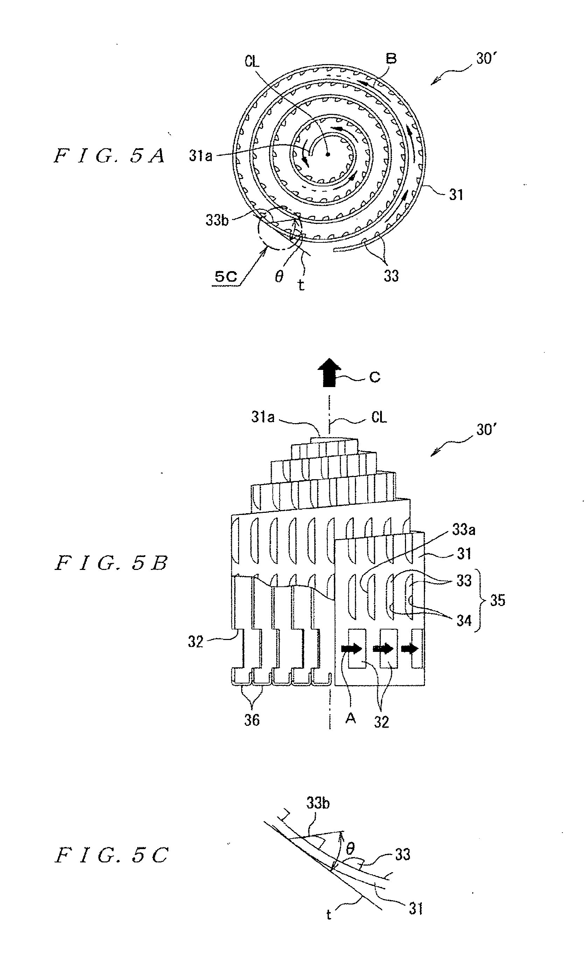

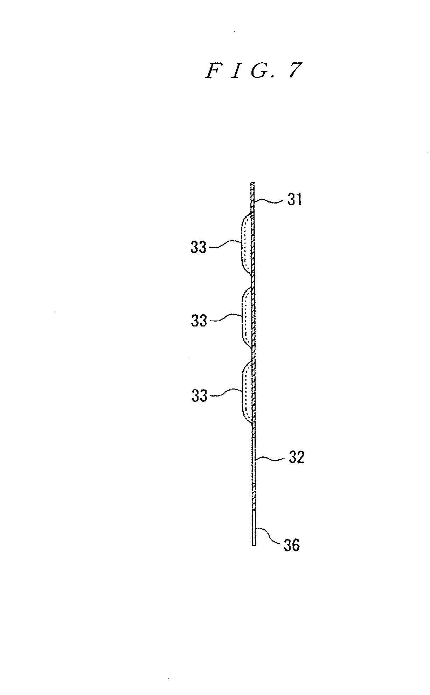

Next, a modified example of the heatsink 30 used in the heating element cooling apparatus of FIG. 1 will be described with reference to FIGS. 5A through 7.

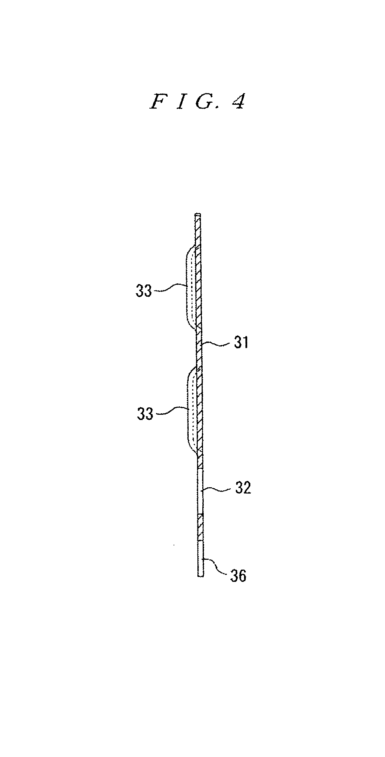

The heatsink 30' shown in FIGS. 5A, 5B and SC has the same basic construction as the heatsink 30 shown in FIGS. 2A, 2B and 2C. Parts that are the same as the parts shown in FIGS. 2A through 4 are labeled with the same numbers in FIGS. 5A through 7, and a description of these parts is omitted.

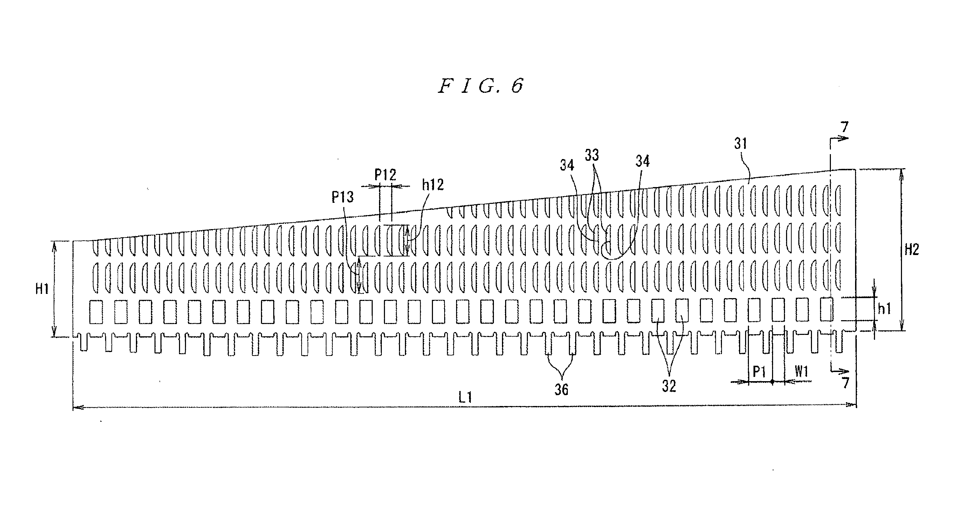

The heatsink 30' shown in FIGS. 5A, 5B and 5C is different from the heatsink 30 shown in FIGS. 2A, 2B and 2C in terms of how the louver-form opening parts 35 are arranged as depicted in FIG. 6. Specifically, the slits 34 are positioned above the air intake openings 32 and arranged in three rows in the vertical direction as shown in FIG. 6. Each slit 34 is formed with a height (length in the vertical direction) of h12, and is smaller than the height h2 in the heatsink 30 shown in FIGS. 2A, 2B and 2C. Furthermore, the slits 34 in each row are arranged along the direction of length of the metal plate 31 at an arrangement pitch of P12 that is smaller than the arrangement pitch P2 of the slits 34 of the heatsink 30 shown in FIGS. 2A, 2B and 2C. Moreover, the upper-row slits 34, middle-row slits 34, and lower-row slits 34 are arranged at a pitch of P13 which is smaller than the pitch P3.

In the heatsink 30', it is preferable to appropriately select the manner of the arrangement of the louver-form opening parts 35 either as shown in FIGS. 5A through 7 or as shown in FIGS. 2A through 4 according to the magnitude of the power consumption of the LED 3.

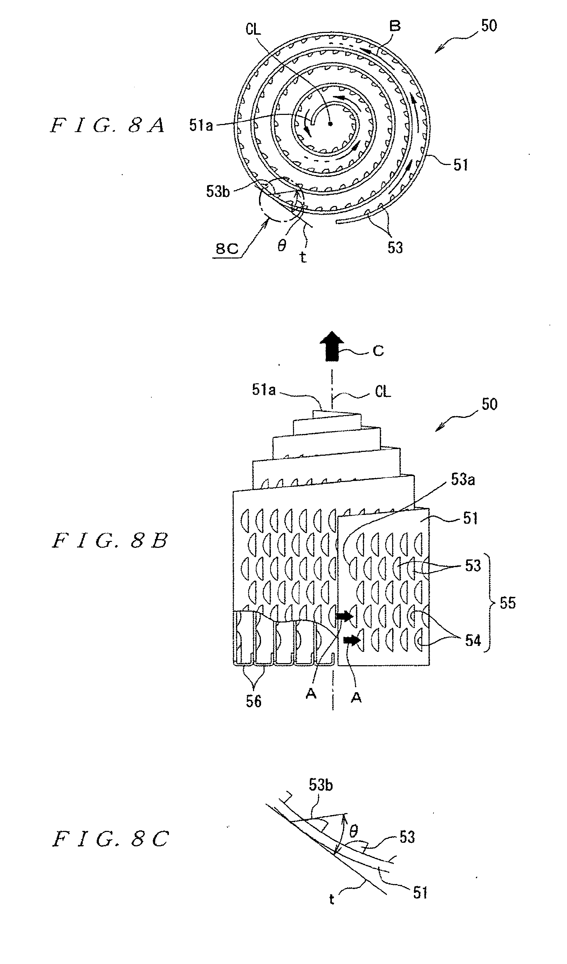

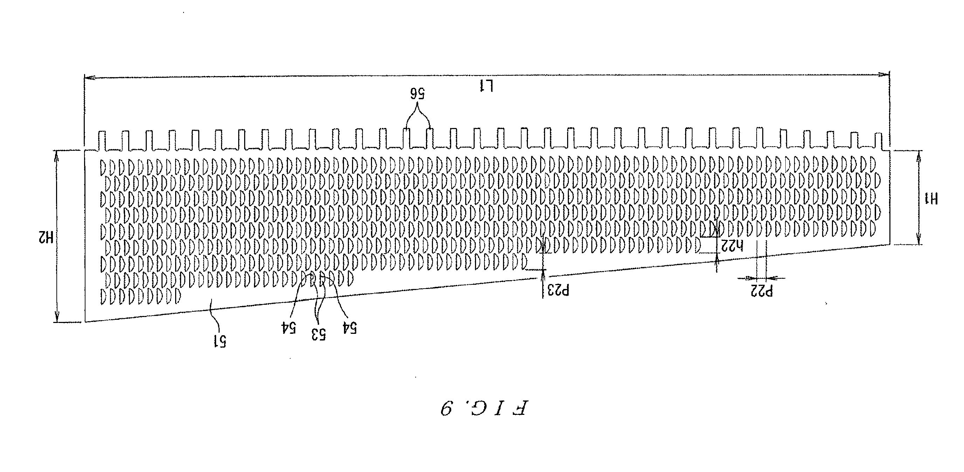

Next, the heatsink according to a second embodiment of the present invention will be described with reference to FIGS. 8A, 8B, 8C and 9.

The heatsink 50 shown in FIGS. 8A, 8B and 8C can be used in the lighting device 1 shown in FIG. 1, and is formed by rolling a band-form metal plate 51 in the shape of a scroll with the rolled central axis CL as the center as shown in FIGS. 8A and 8B. The direction of rolling of the metal plate 51 is clockwise as seen in plan view in FIG. 8A, but may also be reversed, i.e., counterclockwise. As is shown in FIG. 9, the metal plate 51 that is in the unrolled state has a trapezoidal shape, with the height at one end edge in the direction of length (left-right direction in FIG. 9) being designated as H1, and the height at the other end edge in the direction of length being designated as H2 which is higher than H1. The lower end edge (lower end edge in FIG. 9) of the metal plate 51 extends so as to be orthogonal to both the first end edge and second end edge in the direction of length, while the upper end edge of the metal plate 51 extends at an inclination from the first end edge to the second end edge in the direction of length. Therefore, when the metal plate 51 is rolled (like a scroll) such that the second end edge having the height H2 is on the inside, the height on one side (upper side) in the direction of the central axis is gradually increased from the outside in the radial direction toward the central portion 51 a in the radial direction.

Furthermore, a plurality of louver-form opening parts 55 are formed in the heatsink 50 as shown in FIGS. 8A and 8B. Each of the opening parts 55 comprises a circular arc-shaped fin 53 that is cut and raised by stamping and being inwardly formed in the radial direction and a slit-form opening (hereafter simply referred to as slit) 54 being produced as a result of forming the fin 53. The manner in which the fins 53 are cut and raised is the same as in the fins 33 of the heatsink 30 shown in FIGS. 2A and 2B, and each of the plurality of fins 53 is cut and raised from the heatsink 50 (metal plate 51) such that the line 53a connecting both raised end parts extends parallel to the direction of the central axis of the heatsink 50, i.e., in the direction of extension of the louver. Moreover, each of the plurality of fins 53 is cut and raised from the heatsink 50 such that the plane 53b of each fin 53 extends parallel to the direction of the central axis, i.e., in the vertical direction, and also such that the angle θ formed by the plane 53b of each fin 53 and the tangential line t of the scroll-form heatsink 50 (metal plate 51) is an acute angle as shown in FIG. 8A.

In addition, the slits 54 are arranged in nine rows in the vertical direction as shown in FIG. 9. These slits 54 are arranged in a zigzag fashion along the vertical direction from the slits 54 in the uppermost row to the slits 54 in the lowermost row. These slits 54 are arranged along the vertical direction at a pitch of P23 from the uppermost-row slits 54 to the lowermost-row slits 54. Each slit 54 is formed with a height (length in the vertical direction) of h22. The slits 54 in each row are arranged at a pitch of P22 along the direction of length of the metal plate 51. The height h22 of each slit 54 is smaller than the height h2 of the slits 34 in the heatsink 30 shown in FIG. 2.

Furthermore, a plurality of leg parts 56 are provided on the lower end edge of the heatsink 50 (metal plate 51) at a specified pitch along the direction of length. These leg parts 56 are bent after the metal plate 51 is rolled into the shape of a scroll with the rolled central axis CL as the center such that the leg parts 56 on the outside in the radial direction respectively touch the metal plate 51 on the inside in the radial direction as shown in FIG. 8B.

Moreover, as in the heatsink 30 shown in FIG. 1, the undersurfaces of the leg parts 56 are brazed (soldered) by reflow to the Cu layer formed on the upper surface of the printed wiring board 20, thus mounting the heatsink 50 on the printed wiring board 20. In this case, the heatsink 50 is mounted on the upper surface of the printed wiring board 20 in the vertical direction in relation to the LED 3 in a position in which the LED 3 is located in the center in the radial direction.

Here, in the heatsink 50 shown in FIGS. 8A through 9, there are no openings having the same shape as the air intake openings 32 that are formed in the heatsink 30 shown in FIGS. 2A through 4. In the heatsink 50 shown in FIGS. 8A through 9, the louver-form opening parts 55 that are formed toward the lower end of the heatsink 50 in the direction of the central axis in approximately two rows from the bottom have the same function as the air intake openings 32, and constitute the "air intake openings" referred to in claim 1. Accordingly, air is taken into the interior of the heatsink 50 as indicated by arrow A from the outside of the heatsink 50 through the opening parts 55 in approximately two rows from the bottom as shown in FIG. 8B.

It is preferable to appropriately select whether to use the heatsink 50 shown in FIGS. 8A through 9 or whether to use the heatsink 30 or 30' shown in FIGS. 2A through 7 according to the magnitude of the power consumption of the LED 3.

In addition, by using the heatsink 50 shown in FIGS. 8A through 9, the surface area of the heatsink 50 can be made to be different from the surface area of the heatsink 30 or 30'.

Embodiments of the present invention have been described above. However, the present invention is not limited to these embodiments, and various alterations and modifications can be made.

For example, the leg parts 36 or 56 of the heatsink 30, 30', or 50 are brazed (soldered) to the printed wiring board 20. However, it would also be possible to interpose an aluminum plate (not shown in the figures) as a heat transfer member between the printed wiring board 20 and the heatsink 30, 30', or 50.

Furthermore, the size, number, and arrangement of the fins 33 or 53 and slits 34 or 54 that respectively constitute the louver-form opening parts 35 or 55 and the air intake openings 32 may be determined appropriately according to the magnitude of the power consumption of the LED 3.

Moreover, a lighting device that uses an LED as a heating element is described as an example in the present embodiments. However, the heatsinks 30, 30', and 50 and lighting device 10 can be applied to any device that is used to cool an electronic component other than an LED or another heating element.

## Claims

1. A heatsink (30) for cooling a heating element (3), comprising
a metal plate (31) in the form of a band rolled around a central axis (CL) to have the shape of a scroll and having a base edge (L1) wherein the height of the scroll from the base edge (L1) gradually increases towards the central axis (CL), and
a plurality of air intake openings (32) that pass through the metal plate (31) and are in a lower portion of the metal plate (31) in the vicinity of the base edge (L1).

2. The heatsink according to claim 1, wherein the scrolled metal plate (31) has a plurality of fins (33) cut and raised inwardly in the radial direction from the plate (31) about a fin axis substantially parallel to the central axis (CL), the fins (33) projecting towards the central axis (CL).

3. The heatsink according to claim 2, wherein each said fin (33) defines a fin plane between its fin axis and a distal end of the fin (33), wherein an angle (θ) formed between said fin plane and a plane (t) extending tangentially from the scrolled metal plate (31) at said fin axis is an acute angle.

4. The heatsink according to claim 2 or 3, wherein each said fin (33) has an arc-shape in section.

5. The heatsink according to claim 4, wherein each said fin (33) has a concave arc-shape in section.

6. A cooling apparatus (10) comprising the heatsink (30) according to any preceding claim, a heating element (3) and a printed circuit board (20), the heatsink (30) being mounted on one side of the printed circuit board (20) and the heating element (3) being mounted on the opposite side of the printed circuit board (20), the heating element (3) being located in a substantially central position with reference to the central axis (CL) and opposite the heatsink (30).
